# FASCICULE DE BREVET EUROPEEN

(11) **EP 4 561 292 B1**
(45) Date de publication et mention de la délivrance du brevet: **21.10.2026**
(21) Numéro de dépôt: 24214025.9
(22) Date de dépôt: 19.11.2024
(51) Int. Cl.: H10D 30/40, H10D 48/00, H10D 62/10, H10D 62/81, H10D 64/27, B82Y 10/00

(54) **DISPOSITIF A STRUCTURE DE DETECTION A BLOCAGE DE COULOMB SUPERPOSEE A UNE BOITE QUANTIQUE**
VORRICHTUNG MIT EINER AUF EINEM QUANTENKASTEN ÜBERLAGERTEN COULOMB-BLOCKADE-DETEKTIONSSTRUKTUR
DEVICE HAVING A COULOMB BLOCKADE SENSING STRUCTURE STACKED UPON A QUANTUM DOT

(30) Priorité: 21.11.2023 FR 2312781
(43) Date de publication de la demande: 28.05.2025
(73) Titulaire: Commissariat à l'Energie Atomique et aux Energies Alternatives, 75015 Paris (FR)
(72) Inventeur: BERTRAND, Benoit, 38054 Grenoble Cedex 09 (FR); MORTEMOUSQUE, Pierre-André, 38054 Grenoble Cedex 09 (FR)
(74) Mandataire: Santarelli

(56) Documents cités:
- FR-A1- 3 066 297
- US-A1- 2011 085 381
- US-A1- 2019 221 659
- US-A1- 2020 365 656

## Description

### DOMAINE TECHNIQUE ET ÉTAT DE LA TECHNIQUE ANTÉRIEURE

La présente demande se rapporte au domaine des dispositifs quantiques dans lesquelles au moins un bit d'information quantique basée sur un état quantique donné parmi au moins deux niveaux mesurables est utilisé comme vecteur d'information. Cet état quantique est appelé qubit ou bit quantique ou encore « quantum bit » en anglais.

Un type particulier de qubit est le qubit de spin lorsqu'on utilise le degré de liberté intrinsèque du spin d'électrons individuels pour coder l'information quantique.

Les qubits peuvent être formés dans un matériau semi-conducteur au sein de structures de confinement de tailles nanométriques et définies de manière électrostatique. Ces structures de confinement sont typiquement appelées « boites quantiques » (« quantum dots » en anglais).

Une boîte quantique se comporte comme un puits de potentiel confinant une ou plusieurs charges élémentaires (électrons ou trous) dans une région de semi-conducteur.

Pour mesurer l'état d'un qubit, il est connu de procéder à une conversion spin/charge qui permet de convertir l'état de spin des particules chargées en un état de charge des boites quantiques contenant lesdites particules. Il est alors nécessaire de mesurer cet état de charge afin d'en déduire l'état de spin des particules chargées avant conversion. Pour cela, un moyen de mesure de l'état de charge est en général disposé en regard de chaque boite quantique.

La lecture d'un qubit peut être en particulier réalisée en utilisant une autre boîte quantique appelée « ilot de lecture » ou « ilot de détection » couplée à celle du qubit destiné à être lu. Ces deux éléments forment deux puits de potentiel séparés par une barrière de potentiel.

Des dispositifs dans lesquels les ilots de détection et boites quantiques sont disposées en regard et dans un même plan parallèle au plan principal d'un substrat sur lequel les ilots de détection et boites quantiques et boites quantiques sont formées sont connus.

Ils posent des problèmes d'encombrement. Par ailleurs, du fait de contraintes de fabrication de tels dispositifs, les possibilités de rapprochement entre structure de détection et boite quantique sont limitées, ce qui peut nuire à la sensibilité de détection.

Le document FR 3066297, émanant du demandeur, prévoit un dispositif quantique dans lequel selon un mode de réalisation, la structure de détection peut être située dans un plan distinct de celui des boites quantiques. Des grilles de commande électrostatiques sont prévues entre un niveau dans lequel les boîtes quantiques sont formées et un niveau dans lequel des détecteurs de charge sont prévus. Un tel dispositif pose problème en termes de complexité de mise en œuvre de son procédé de fabrication.

Des dispositifs quantiques sont également connus des documents US 2020/0365656 A1, US 2019/0221659 A1 et US 2011/0085381 A1.

Il se pose le problème de réaliser un dispositif quantique amélioré vis-à-vis d'au moins un des inconvénients mentionnés ci-dessus.

### EXPOSÉ DE L'INVENTION

Selon un aspect, la présente invention concerne un dispositif quantique formé à partir d'un substrat revêtu :
- d'au moins une région semi-conductrice dans laquelle une boite quantique est apte à être formée,
- au moins un premier bloc de grille pour moduler le potentiel de la boite quantique et formant un réservoir de charges,
- une structure de détection pour détecter un état de charge de ladite boite quantique, ladite structure de détection comportant un ilot de détection disposé au-dessus et en regard de la boite quantique et apte être couplé à la boite quantique par couplage électrostatique, ladite structure de détection comportant en outre au moins une première jonction tunnel entre ledit ilot de détection et le premier bloc de grille, le premier bloc de grille étant juxtaposé audit ilot de détection.

La région semi-conductrice est typiquement située à un premier niveau du dispositif, autrement dit dans un premier plan parallèle à un plan principal du substrat, tandis que le premier bloc de grille et la structure de détection sont agencées dans un deuxième niveau autrement dit dans un deuxième plan parallèle à un plan principal du substrat.

Un tel agencement à boite quantique et ilot de détection superposés permet de conférer une empreinte réduite dans le plan et de réaliser un agencement rapproché de l'ilot de détection vis-à-vis de la boite quantique, ce qui permet de pouvoir établir un bon couplage capacitif entre ilot de détection et boite quantique et de parfaire ainsi la sensibilité de détection. Un tel agencement des éléments précités permet également de rendre plus aisée l'intégration dans une matrice dotée d'une ou plusieurs rangées de boites quantiques et de structures de détection associées.

Selon un premier mode de réalisation du dispositif quantique et de la structure de détection, un deuxième bloc de grille distinct du premier bloc de grille et situé dans un même premier plan que le premier bloc de grille et l'ilot de détection, le premier plan étant parallèle à un plan principal du substrat, le deuxième bloc de grille, étant agencé de sorte que l'ilot de détection est disposé entre le premier bloc de grille et le deuxième bloc de grille, la structure de détection de charge étant pourvue d'une deuxième jonction tunnel formée entre l'ilot de détection et le deuxième bloc de grille.

Avec un tel agencement, on peut mettre en œuvre une détection de l'état de charge de la boite quantique en polarisant de manière adéquate le premier bloc et le deuxième bloc de grille de sorte à faire passer un courant à travers les jonctions tunnel. Le niveau de courant renseigne alors sur l'état de charge de la boite quantique.

Pour prendre contact sur le premier bloc de grille, un premier plot de contact peut être prévu sur ce premier bloc de grille.

De même, pour prendre contact sur le deuxième bloc de grille, un deuxième plot de contact peut être également prévu sur ce deuxième bloc de grille.

Selon une possibilité de mise en œuvre, l'ilot de détection peut être à base d'un même matériau conducteur ou semi-conducteur dopé que le ou les blocs de grille.

Avantageusement, le premier plot de contact et le deuxième plot de contact sont prévus, respectivement, pour :
- lors d'une phase de fonctionnement dite « de détection » appliquer respectivement un premier potentiel au premier bloc de grille et un deuxième potentiel au deuxième bloc de grille différent du premier potentiel de sorte à permettre le passage d'un courant à travers lesdites première et deuxième jonction et,
- lors d'au moins une autre phase de fonctionnement distincte de ladite phase de fonctionnement de détection : appliquer un même potentiel donné au premier bloc de grille et au deuxième bloc de grille.

L'application du même potentiel donné permet d'empêcher la circulation du courant, qui peut s'avérer gênante pendant l'opération des qubits et pour pallier des problématiques d'échauffement local du dispositif et de bruit de charge généré à proximité de la boite quantique qui seraient susceptibles de perturber l'état du qubit pendant les opérations.

Avantageusement, le dispositif peut être muni en outre d'un étage de mesure du courant à travers lesdites première jonction et deuxième jonction couplé au premier plot de contact et au deuxième plot de contact.

Selon un deuxième mode de réalisation du dispositif quantique, le dispositif peut comporter en outre un premier plot de contact sur le premier bloc de grille, le premier plot de contact étant couplé à un circuit d'un dispositif de mesure par réflectométrie, ledit circuit étant en particulier configuré pour :
- émettre un signal RF sur le premier plot de contact à destination dudit ilot de détection ;
- détecter une variation de la phase et/ou d'amplitude d'un signal RF réfléchi par ledit ilot consécutivement à ladite émission.

Avantageusement, que ce soit pour le premier mode ou le deuxième mode de réalisation, le dispositif peut être muni d'un plot conducteur pour un contrôle électrostatique dudit ilot de détection, ledit plot conducteur étant disposé au-dessus et en regard dudit ilot de détection et séparé dudit ilot de détection par le biais d'au moins une région diélectrique de sorte à permettre un couplage électrostatique entre ledit plot conducteur et ledit ilot de détection.

Selon un mode de réalisation particulier du dispositif, le plot conducteur peut être disposé en contact d'une région de matériau conducteur ou semi-conducteur séparée de l'ilot de détection par l'intermédiaire de la région diélectrique, ledit ilot de détection étant à base du même matériau que ladite région de matériau conducteur ou semi-conducteur.

Avantageusement, le plot conducteur est disposé en contact d'une région de matériau conducteur ou semi-conducteur dopé séparée de l'ilot de détection par l'intermédiaire d'une région diélectrique, ladite région de matériau conducteur ou semi-conducteur dopé, ladite région diélectrique, ledit ilot de détection ayant une même empreinte et formant un même motif.

Selon un autre aspect, la présente invention concerne un procédé de fabrication d'un dispositif quantique tel que défini plus haut.

Selon un autre aspect, la présente invention concerne un procédé de fabrication d'un dispositif quantique comprenant les étapes suivantes :
- prévoir un substrat revêtu d'au moins une couche semi-conductrice, au moins une région de ladite couche semi-conductrice étant apte à former une boite quantique,
- former un barreau à base d'au moins un matériau conducteur ou semi-conducteur dans lequel au moins un ilot de détection en regard de ladite boite quantique est prévu,
- former au moins une région de diélectrique tunnel sur au moins un flanc latéral dudit barreau,
- former un ou plusieurs blocs de grille juxtaposés audit barreau et s'étendant principalement dans une direction orthogonale à une direction principale dans laquelle s'étend ledit barreau, au moins un premier bloc grille parmi lesdits blocs de grille étant disposé contre la région de diélectrique tunnel agencée sur ledit ilot de détection, de sorte à former une jonction tunnel entre le premier bloc grille et l'ilot de détection.

Avantageusement, lesdits un ou plusieurs blocs de grille peuvent être formés par :
- dépôt d'au moins un matériau de grille, puis :
- gravure dudit matériau de grille, ladite gravure étant réalisée concomitamment à une gravure du barreau pour former l'ilot de détection.

Selon un mode de réalisation particulier, ledit barreau peut être à base dudit matériau de grille.

Avantageusement, la région de diélectrique tunnel peut être formée par dépôt d'une couche de diélectrique tunnel sur le barreau puis par gravure de la couche diélectrique tunnel, la gravure de la couche diélectrique tunnel et la gravure dudit barreau pour former l'ilot de détection et la gravure dudit matériau de grille étant effectuées en utilisant un même masquage.

En variante la région de diélectrique tunnel peut être formée par oxydation dudit barreau.

Selon une possibilité de mise en œuvre, le barreau est appelé «°barreau supérieur » et formé par dépôt d'un matériau conducteur puis gravure du matériau conducteur en utilisant un masquage, ladite gravure du matériau conducteur étant prolongée dans la couche semi-conductrice et de sorte à former un autre barreau appelé barreau « inférieur » et reproduisant avantageusement la forme du barreau supérieur.

Avantageusement, à l'issue de ladite gravure pour former le barreau inférieur, des flancs latéraux du barreau inférieur sont dévoilés. Le procédé peut alors comprendre en outre : après formation dudit barreau inférieur et préalablement à la formation de ladite région de diélectrique tunnel, des étapes de :
- dépôt d'un ou plusieurs couches isolantes,
- gravure desdites une ou plusieurs couches isolantes de sorte à former des blocs de protection isolants de part et d'autre des faces latérales de la région semi-conductrice,
- formation d'une région de diélectrique tunnel par dépôt d'une couche de diélectrique tunnel sur le barreau supérieur tandis que des flancs latéraux du barreau inférieur sont protégés.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels:
La Figure 1 représente schématiquement un exemple de dispositif quantique selon un premier mode de réalisation dans laquelle chaque boite quantique est associée à une structure de détection à blocage de Coulomb disposée au-dessus et en regard de cette boite quantique.
La Figure 2 représente schématiquement une variante réalisation du dispositif quantique pour laquelle chaque boite quantique est formée dans un bloc semi-conducteur de largeur de l'ordre de celle d'un ilot de détection de ladite structure de détection placé en regard de la boite.
La Figure 3 représente schématiquement une variante de mise en œuvre du dispositif quantique pour laquelle la structure de détection est associée à un dispositif de mesure par réflectométrie.
La Figure 4 illustre un exemple de substrat de départ possible pour mettre en œuvre un dispositif quantique suivant l'invention.
La Figure 5, la Figure 6A, la Figure 6B illustrent une réalisation d'un barreau conducteur ou semi-conducteur dans lequel une ou plusieurs boites quantiques sont destinées à être formées.
La Figures 7, la Figure 8, la Figure 9A, la Figure 9B illustrent une mise en œuvre d'une pluralité de grilles de contrôle électrostatique d'un ilot quantique et de définition par gravure concomitante pour réaliser cet ilot quantique et ces grilles.
La Figure 10, la Figure 11, la Figure 12A, la Figure 12B, illustrent la réalisation optionnelle de d'une siliciuration du sommet des blocs de grille lorsque ceux-ci sont semi-conducteurs.
La Figure 13, la Figure 14A, la Figure 14B, la Figure 15A, la Figure 15B, la Figure 16A, la Figure 16B, la Figure 17, la Figure 18, la Figure 19A, la Figure 19B, la Figure 20, la Figure 21, la Figure 22 illustrent un autre exemple de procédé de fabrication d'un dispositif quantique tel que mis en œuvre suivant la présente invention.
La Figure 23 illustre une variante de réalisation pour laquelle une extrémité inférieure d'un plot pour le contrôle par couplage électrostatique d'un ilot de détection est agencée en contact d'une couche conductrice ou semi-conductrice prévue au-dessus de l'ilot de détection et séparée de l'ilot par une région diélectrique.

Des parties identiques, similaires ou équivalentes des différentes figures décrites ci-après portent les mêmes références numériques de façon à faciliter le passage d'une figure à l'autre.

En outre, dans la description ci-après, des termes qui dépendent de l'orientation de la structure tels que « au-dessus », « au-dessous », « arrière », « avant », « supérieur », « inférieur », s'appliquent en considérant que la structure est orientée de la façon illustrée sur les figures.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

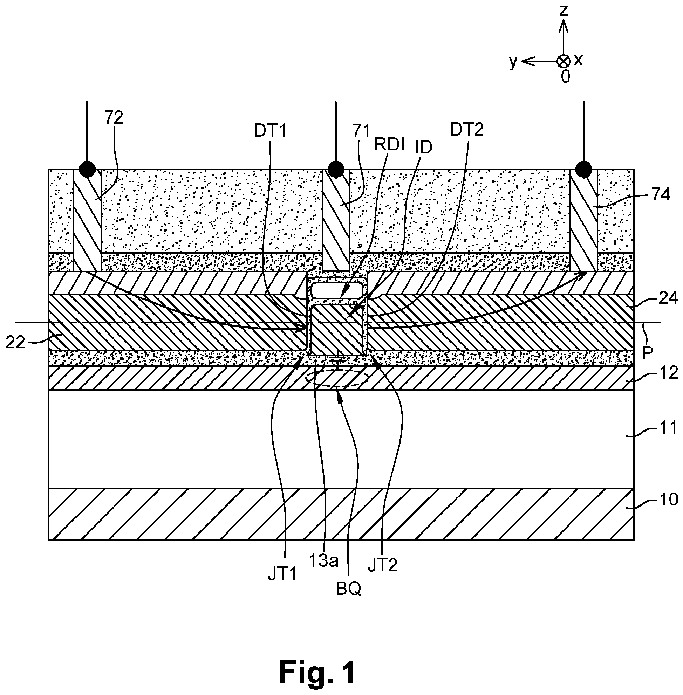

On se réfère tout d'abord à la figure 1 qui donne un exemple de réalisation d'un dispositif quantique selon un premier mode de réalisation.

Dans l'exemple de réalisation particulier donné sur cette figure, une boite quantique BQ est formée dans une région d'une couche semi-conductrice 12. Cette couche semi-conductrice 12 peut être la couche superficielle d'un substrat ou une couche reportée ou déposée sur un substrat et formée d'un matériau semi-conducteur ou de plusieurs matériaux semi-conducteurs empilés.

Selon un exemple de réalisation particulier, la couche semi-conductrice 12 est la couche superficielle d'un substrat de type semi-conducteur sur isolant, en particulier une couche de silicium d'un substrat SOI (SOI pour « Silicon On Insulator » ou silicium sur isolant), par exemple du ²⁸Si. Selon un autre exemple de réalisation la couche semi-conductrice 12 peut être formée d'une hétérostructure, par exemple de SiGe/Si.

La boite quantique BQ assure le confinement d'au moins une charge élémentaire (électrons ou trous). De préférence, la boite quantique BQ comporte ici une seule charge élémentaire. Le spin de cette charge, en particulier un électron, peut être prévu pour coder l'information quantique. Dans ce cas, le qubit associé à la boite quantique BQ est un qubit de spin.

Pour permettre la détection de la boite quantique BQ une structure de détection de charge est prévue à proximité et ici au-dessus de la boite quantique BQ. Le fonctionnement de cette structure de détection de charge repose sur un couplage capacitif également appelé « couplage électrostatique » entre la boite quantique BQ et un ilot de détection ID agencé au-dessus et en regard de la boite quantique BQ. L'ilot de détection ID est réalisé dans un bloc, typiquement conducteur ou semi-conducteur, et séparé de la boite quantique BQ par l'intermédiaire d'une région isolante 13a. Cette région isolante 13a peut être une zone d'une couche isolante recouvrant la couche semi-conductrice superficielle 12. La composition de la région isolante 13a, par exemple en oxyde de silicium, et l'épaisseur de cette couche isolante, par exemple comprise entre 2 nm et 20 nm, avantageusement entre 5 nm et 10 nm sont prévues pour permettre un couplage entre la boite quantique BQ et un ilot de détection ID. Un tel couplage dépend de la capacité entre l'ilot de détection ID et la boite quantique BQ en termes de surfaces respectives en regard l'une de l'autre, d'épaisseur de la couche isolante les séparant et de constante diélectrique de l'isolant les séparant. Un tel agencement de boite quantique BQ et d'ilot de détection ID superposés permet de minimiser la distance boite quantique - détecteur pour garantir une bonne sensibilité du détecteur.

Le dispositif est ici doté d'un premier bloc 22 de grille et d'un deuxième bloc 24 de grille situés au-dessus de la couche semi-conductrice 12 et de part et d'autre de l'ilot ID. Ces blocs de grilles 22, 24 servent de réservoir de charge(s) et également à ajuster le potentiel de la boite quantique BQ. Ils sont prévus pour être bons conducteurs - y compris aux températures cryogéniques d'utilisation du dispositif.

Le premier bloc 22 de grille et le deuxième bloc 24 de grille sont prévus typiquement à base d'un matériau semi-conducteur dopé tel que par exemple du polysilicium, ou bien à base d'un matériau conducteur tel que par exemple du TiN. Le premier bloc 22 de grille est ici situé dans un même plan P parallèle à un plan principal du substrat que l'ilot de détection ID, ce plan P étant disposé au-dessus de la couche semi-conductrice 12 dans laquelle la boite quantique est agencée. Par plan principal du substrat on entend un plan passant par le substrat et parallèle au plan [O ;x;y] du repère orthogonal [O ;x ;y ; z] donné sur la figure 1.

Le premier bloc 22 de grille et le deuxième bloc 24 de grille sont séparés de la région 12a semi-conductrice dans laquelle la boite quantique BQ est réalisée par au moins une couche isolante.

La structure de détection de charge est une structure de type à blocage de Coulomb ici basée sur le passage d'un courant à travers l'ilot ID en regard de la boite quantique BQ. Une détection de ce courant renseigne sur l'état de charge de cette boite BQ.

La structure à blocage de Coulomb est dotée d'une première jonction tunnel JT1 entre l'ilot de détection ID disposé au-dessus et en regard de la boite quantique BQ et une portion du premier bloc 22 de grille juxtaposée à l'ilot de détection ID. Le premier bloc 22 de grille et l'ilot de détection ID sont séparés par le biais d'une région de diélectrique tunnel DT1.

Dans cet exemple de réalisation particulier, le deuxième bloc 24 de grille est juxtaposé à l'ilot de détection ID et situé dans le même plan P que l'ilot de détection ID et le premier bloc 22 de grille, de sorte que l'ilot de détection ID est disposé entre le premier bloc 22 de grille et le deuxième bloc 24 de grille. Une deuxième jonction tunnel JT2 est prévue entre l'ilot de détection ID et le deuxième bloc 24 de grille. Le deuxième bloc 24 de grille et l'ilot de détection ID sont séparés par le biais d'une région de diélectrique tunnel DT2. La structure à blocage de Coulomb a ainsi, dans cet exemple de réalisation particulier, un fonctionnement semblable à un transistor à électron unique (SET pour « Single Electron Transistor »). Les blocs 22, 24 de grille peuvent être ici assimilés respectivement à une région de source et une région de drain du transistor. On contrôle ainsi le passage d'un courant de ce transistor SET en fonction de potentiels respectifs appliqués sur les blocs 22, 24 de grille.

Des plots 72, 74 de contact conducteurs connectés aux blocs 22, 24 de grille sont ici de préférence prévus pour permettre de leur appliquer des potentiels de polarisation respectifs. En fonction des potentiels de polarisation appliqués respectivement au plot 72 et au plot 74, un courant (matérialisé de manière schématique par des flèches) peut être amené à circuler à travers les jonctions JT1, JT2 et l'ilot de détection ID.

Hors utilisation de la structure à blocage de coulomb comme détecteur de charge, en particulier lorsqu'on initialise, contrôle ou maintient au repos le qubit stocké dans la boite quantique sans lire d'état de charge, les plots de contacts 72, 74, et par conséquent les blocs de grille 22, 24 peuvent être mis à un même premier potentiel V_{G1}. Le transistor SET est alors dans un mode de fonctionnement bloqué de sorte qu'on empêche une circulation de courant à travers les jonctions JT1, JT2.

Ce potentiel V_{G1} est réglable et peut être fixé lorsqu'on initialise la boite quantique BQ, de sorte à permettre d'imposer un état de charge donné à cette boite quantique. L'initialisation de la boite quantique BQ peut être alors mise en œuvre par l'intermédiaire des blocs 22, 24 de grille. Les blocs de grilles de part et d'autre de l'ilot de détection ID sont maintenus au potentiel V_{G1}. Les jonctions tunnel autorisent le passage de charge et le remplissage de l'ilot ID jusqu'à ce que les potentiels entre blocs 22, 24 de grilles et l'ilot quantique soient équilibrés à une résolution de l'ordre de quelques mV ou inférieure près, non impactante pour l'ajustement du potentiel de la boite quantique.

Les blocs de grille eux-mêmes ont une influence et contribuent à cet ajustement pour éventuellement aller en-deçà de la résolution imposée par le blocage de coulomb.

Lors d'une phase d'utilisation de la structure à blocage de coulomb comme détecteur de charge, une différence de potentiels ΔV_{SD}^{SET} est appliquée entre les plots de contacts 72, 74. Les plots de contacts 72, 74 sont alors mis à des potentiels respectifs V_{G2} et V_{G3} distincts tels que V_{G3} - V_{G2} = ΔV_{SD}^{SET} avec ΔV_{SD}^{SET} ≠ 0, de sorte à permettre un passage de courant (matérialisé par deux flèches sur la figure 1) à travers la structure à blocage de Coulomb.

Selon un exemple de réalisation particulier, les potentiels respectifs V_{G2} et V_{G3} appliqués aux blocs de grille 22, 24 peuvent être tels que V_{G2} = V_{G1} et V_{G3} = V_{G1} + ΔV_{SD}^{SET}.

La valeur du courant résultant de cette polarisation particulière dépend, et renseigne par conséquent, sur l'état de charge de la boite quantique BQ située en regard et en dessous l'ilot de détection ID. Une détection de ce courant peut être réalisée par le biais d'un circuit de détection de courant que l'on connecte aux plots de contact 72, 74.

Une tension arbitraire VG peut être appliquée sur le premier plot de contact 72 par exemple via un étage doté d'un convertisseur numérique analogique (DAC).

La lecture du courant au niveau du deuxième plot de contact 74 peut se faire à l'aide d'un circuit TIA (Amplificateur Trans-Impédance). Pour que ce plot 74 soit également polarisé à une tension contrôlable, on peut par exemple utiliser un convertisseur numérique analogique (DAC) supplémentaire afin d'ajuster la tension de référence du circuit TIA à cette valeur.

De manière optionnelle et avantageuse, l'ilot de détection ID peut être lui-même commandé et couplé par couplage électrostatique à un plot 71 supplémentaire pour conférer un moyen de contrôle électrostatique supplémentaire. Ce plot conducteur 71 est ici disposé au-dessus et en regard dudit ilot de détection ID sans être en contact avec ce dernier. Le plot conducteur 71 est séparé dudit ilot de détection ID par le biais d'au moins une région diélectrique RDI prévue, en particulier en termes de composition et d'épaisseur, de sorte à permettre un couplage électrostatique entre ledit plot conducteur 71 et ledit ilot de détection ID. Par exemple, la région diélectrique RDI est formée d'un matériau diélectrique tel qu'un oxyde de silicium d'épaisseur qui peut être comprise par exemple entre 5 et 15 nm.

En fonction d'un potentiel appliqué au plot conducteur 71, on peut ajuster le potentiel chimique, autrement dit le niveau de Fermi de la structure à blocage de coulomb. Le plot conducteur 71 offre ainsi un degré de réglage supplémentaire pour la structure de détection. La tension appliquée sur ce plot conducteur 71 sert à contrôler le potentiel chimique de l'ilot de détection. En d'autres termes, il permet d'ajuster les niveaux d'énergie discrets de l'ilot de détection ID par rapport au potentiel des blocs 22, 24 de grille, et donc de le basculer d'un régime de blocage de coulomb à un régime non bloqué sans avoir à modifier les tensions appliquées sur les blocs 22, 24 de grille.

En outre, moduler cette tension offre un moyen pour contrôler finement le potentiel de la boite quantique.

Une variante (non représentée) sans ce plot conducteur 71 peut être toutefois prévue. Le contrôle électrostatique de l'ilot de détection ID peut alors se faire par le biais des bloc 22, 24 de grille, ce qui retire toutefois un degré de liberté dans le contrôle de la structure de détection et rend plus complexe la polarisation des différents éléments.

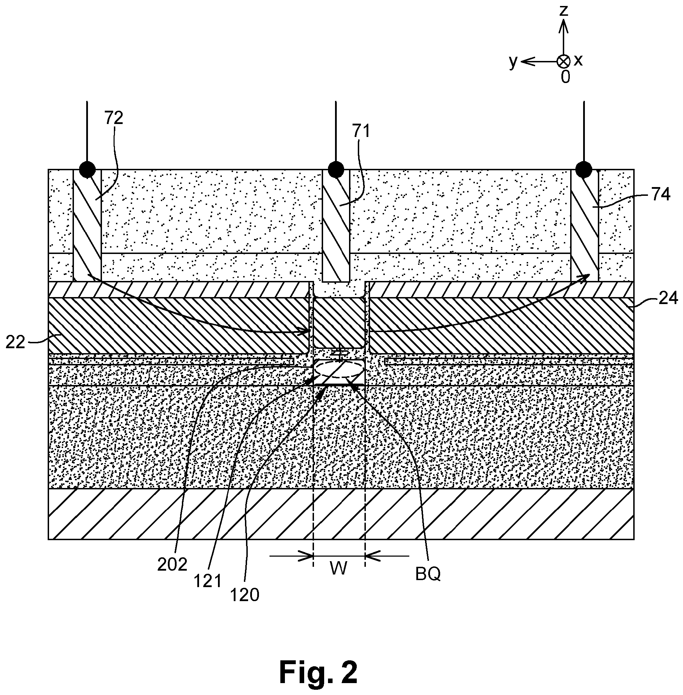

Une variante de réalisation d'un dispositif quantique tel que décrit précédemment est illustrée sur la figure 2. Elle diffère de l'exemple de réalisation décrit précédemment notamment de par la configuration de la région semi-conductrice dans laquelle on prévoit la boite quantique BQ. Dans l'exemple de réalisation particulier donné sur cette figure, la boite quantique BQ est ainsi formée dans une région semi-conductrice qui ne s'étend ici pas sur toute la surface du substrat mais sur une partie seulement de ce substrat. Cette région semi-conductrice peut être en particulier une région d'un bloc 120 semi-conducteur gravé ou reporté.

Le bloc 120 semi-conducteur peut être prévu avec une largeur (dimension mesurée parallèlement à l'axe y du repère orthogonal [O ;x ;y ; z ] donné sur la figure 2) qui est de l'ordre de celle de l'ilot de détection, de préférence égale ou inférieure à celle W de l'ilot de détection ID. La largeur du bloc 120 d'accueil de la boite quantique BQ peut être comprise par exemple entre 20 nm et 100 nm, avantageusement entre 20 nm et 40 nm. Avec un tel agencement, et en positionnant la boite quantique BQ exactement à l'aplomb de l'ilot de détection ID, on peut maximiser la sensibilité de détection.

Avantageusement, pour cette variante de structure, on prévoit une région diélectrique 202 contre les flancs latéraux de la région 12a semi-conductrice qui est de composition et/ou de dimensions différente(s) de celle des zones DT1, DT2 de diélectrique tunnel contre l'ilot ID de détection et prévue de préférence pour empêcher un passage de courant entre les blocs de grille et la boite quantique via les flancs latéraux.

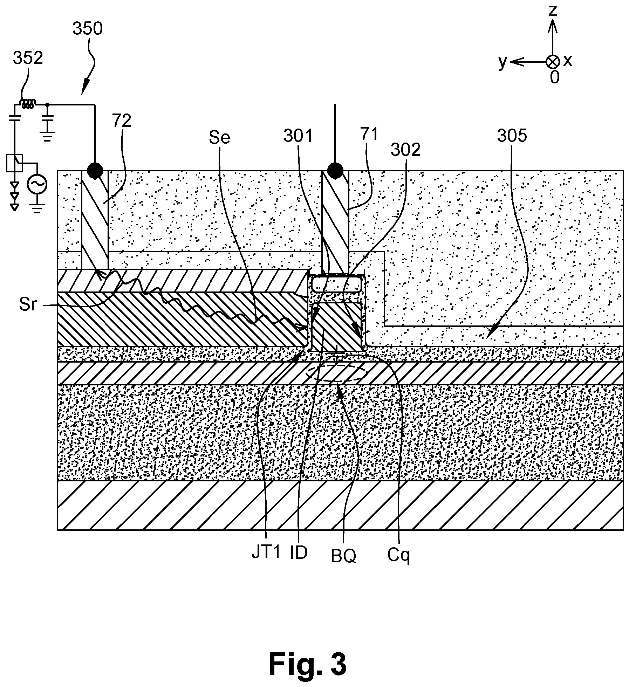

Une variante de l'exemple de réalisation décrit précédemment est illustrée sur la figure 3. La structure à blocage de coulomb diffère de celles décrites précédemment ici notamment en ce qu'elle est munie d'une seule jonction JT1 tunnel formée entre l'ilot de détection ID et un premier bloc 22 de grille juxtaposé à l'ilot de détection ID. Un seul bloc 22 de grille est alors prévu en regard d'un premier flanc latéral 301 de l'ilot de détection ID. A la place d'un deuxième bloc de grille, une région isolante 305 est ici disposée contre un deuxième flanc latéral 302 de l'ilot ID.

La détection de l'état de charge de la boite quantique BQ peut être ici mise en œuvre par réflectométrie. Un plot conducteur 72 prévu pour appliquer un potentiel de polarisation au premier bloc 22 de grille est couplé à un circuit 350 d'un dispositif de réflectométrie configuré pour émettre un signal S_{E} RF sur le plot de contact 72 et recevoir un signal S_{R} RF réfléchi consécutif à l'émission du signal S_{E} RF.

Le signal S_{E} RF est typiquement un signal haute fréquence (par exemple comprise entre 100 MHz et 1 GHz) envoyé sur l'ilot de détection ID. Le signal RF réfléchi par cet ilot ID est ensuite démodulé par le circuit 350. Une inductance 352 est utilisée afin de créer un résonateur LC composé de cette inductance 352 et qui dépend d'une capacité quantique Cq formée par la boite quantique BQ et l'ilot de détection ID. Lorsque la valeur de Cq varie, la phase et l'amplitude du signal réfléchi varient, ce qui peut être détecté par des moyens de mesure. Il est ainsi possible de connaitre l'état relatif de charge de la boîte quantique BQ du qubit destiné à être lu.

Un circuit d'un type tel que décrit par exemple dans le document de R. J. Schoelkopf et al., Science, 280, 5367, pp.1238-1242, 1998 peut être en variante utilisé.

De manière optionnelle, et là encore avantageuse, un plot conducteur 71 peut être prévu au-dessus et à distance de l'ilot de détection ID. Ce plot conducteur 71 est séparé de l'ilot de détection ID par le biais d'au moins une région diélectrique, et permet d'ajuster le potentiel chimique de la structure à blocage de coulomb par couplage électrostatique avec l'ilot de détection ID.

Hors utilisation de la structure à blocage de coulomb comme détecteur de charge, le plot de contact 72 et par conséquent le bloc de grille 22, peut être maintenu à un potentiel donné, ajustable.

Lors d'une phase d'utilisation de la structure à blocage de coulomb comme détecteur de charge, un signal RF est appliqué sur plot de contact 72. L'amplitude du signal RF réfléchi et prélevé sur le plot de contact 72 apporte une information sur la configuration de charge de l'ilot ID, et donc sur son environnement électrostatique.

Dans l'exemple de la figure 3, la boite quantique BQ est prévue dans une couche semi-conductrice qui peut s'étendre pleine plaque sur le substrat. Là encore, on peut en variante prévoir de réaliser cette boite quantique dans un bloc semi-conducteur gravé ou reporté et dont les dimensions en particulier en termes de largeur sont sensiblement égales ou inférieures à celle de l'ilot ID.

L'un ou l'autre des dispositifs quantiques introduits précédemment peut comporter plus d'une boite quantique BQ. En réalité, un dispositif quantique selon l'invention comporte typiquement plusieurs qubits formés chacun d'au moins une boite quantique pour le stockage de l'information quantique associée à une structure de détection à blocage de Coulomb disposée au-dessus. Les boites quantiques peuvent être ainsi agencées en au moins une rangée voire en plusieurs rangées et selon un agencement matriciel de boites quantiques avec un agencement matriciel correspondant de structures de détection à blocage de Coulomb.

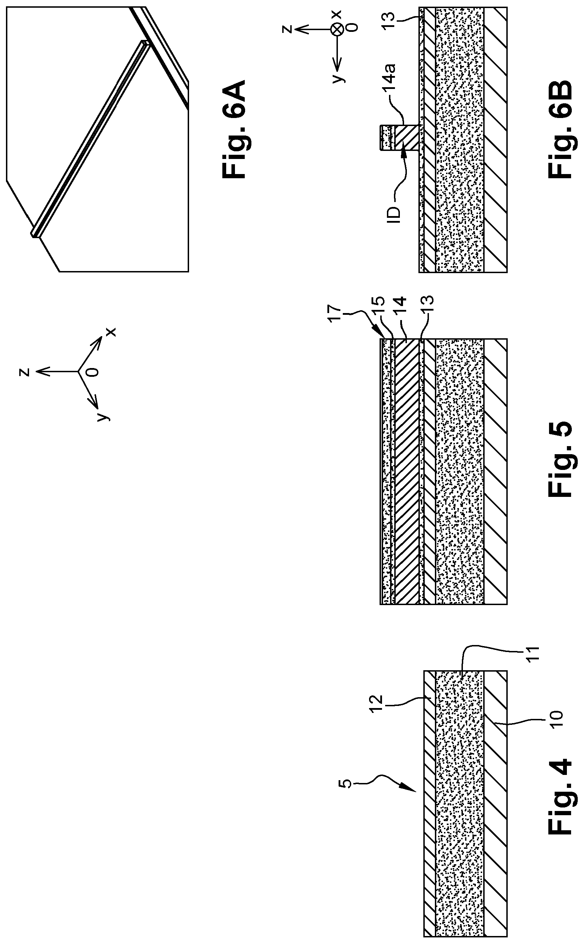

Un exemple de procédé de réalisation d'un dispositif quantique d'un type tel que décrit précédemment, en particulier en lien avec la figure 1 va à présent être donné en lien avec les figures 4 à 12A-12B.

Un matériau de départ possible (figure 4) pour la réalisation du dispositif se trouve ici sous forme d'un substrat 5 de type semi-conducteur sur isolant. Le substrat 5 comporte ainsi une couche 10 dite « de support » en matériau semi-conducteur, une couche isolante 11 disposée sur la couche 11 de support et une couche superficielle 12 semi-conductrice disposée sur la couche isolante. Le substrat 5 est par exemple un substrat SOI dont la couche superficielle 12 est en silicium. La couche superficielle 12 semi-conductrice est ici destinée à accueillir la ou les boites quantiques. Le substrat de type semi-conducteur sur isolant peut être en particulier un substrat de type SOI (pour « Silicon On Insulator » soit « silicium sur isolant ») avec une couche superficielle 12 en silicium, en particulier du ²⁸Si lorsque cette couche est amenée à accueillir des qubits de spin d'électrons. La couche isolante 11 et la couche de support 10 du substrat sont typiquement, respectivement, une couche en oxyde de silicium communément appelée de « BOX » (pour « Burried Oxide » ou « oxyde enterré ») et une couche semi-conductrice, par exemple à base de silicium. L'épaisseur de la couche superficielle 12 est par exemple comprise entre 5 nm et 25 nm, typiquement de l'ordre de 10 nm.

Ensuite, on réalise un ou plusieurs ilots de détection.

Pour cela, on forme un empilement recouvrant la couche semi-conductrice superficielle 12. Cet empilement comprend au moins une couche isolante 13, avantageusement à base d'un diélectrique de grille tel que par exemple de l'oxyde de silicium. Une couche isolante 13 d'épaisseur par exemple comprise entre 5 nm et 15 nm peut être formée.

Un diélectrique dit « high-k », autrement dit de constante diélectrique k élevée tel que par exemple du HfO₂ peut être également employé pour former cette couchez isolante 13.

La couche isolante 13 est surmontée d'au moins une couche 14 de matériau semi-conducteur ou conducteur, typiquement un matériau de grille tel que par exemple du polysilicium d'épaisseur qui peut être par exemple comprise entre 20 nm et 50 nm. La couche 14 de matériau semi-conducteur ou conducteur est revêtue d'au moins une couche diélectrique 15. Un diélectrique de grille formé d'un oxyde de silicium ou un diélectrique « high-k » tel que par exemple du HfO₂ peut être, là encore, également employé. L'empilement réalisé est ensuite recouvert d'au moins une couche 17 de masquage, en particulier de masque dur. Une telle couche de masquage peut être formée d'au moins une couche de matériau isolant, par exemple en SiN et/ou en SiO₂. Dans l'exemple de réalisation illustré la couche de masquage est formé d'un bicouches de SiN et de SiO₂.

On définit ensuite par gravure dans la couche 17 de masquage un ou plusieurs motifs et en particulier au moins un motif, dans l'exemple particulier illustré parallélépipédique, pour former un bloc de masquage. Cela permet de reporter ensuite ce motif dans l'empilement de couches 14, 15 sous-jacentes. Des gravures anisotropes et en particulier à l'aide d'un plasma sont ainsi effectuées pour réaliser le bloc de masquage, puis un bloc d'allure correspondante reproduisant celle du bloc de masquage dans la deuxième couche diélectrique 15 et la couche 14 de matériau de grille.

Une structure susceptible d'être obtenue à l'issue de cette étape est illustrée sur les figures 6A, 6B, donnant respectivement une vue en perspective, une vue en coupe selon un plan de coupe parallèle à un plan [O ;y ;z ] d'un repère orthogonal [O ;x ;y ; z ] donné sur ces figures. La couche 14 forme après gravure un bloc sous forme d'un barreau 14a dans lequel un ou plusieurs ilots de détection ID est ou sont prévus. Dans l'exemple de réalisation particulier illustré, la gravure pour former le bloc 14a est arrêtée sur la première couche isolante 13. La couche isolante 13 peut dans ce cas être conservée de sorte à recouvrir toute la couche superficielle 12.

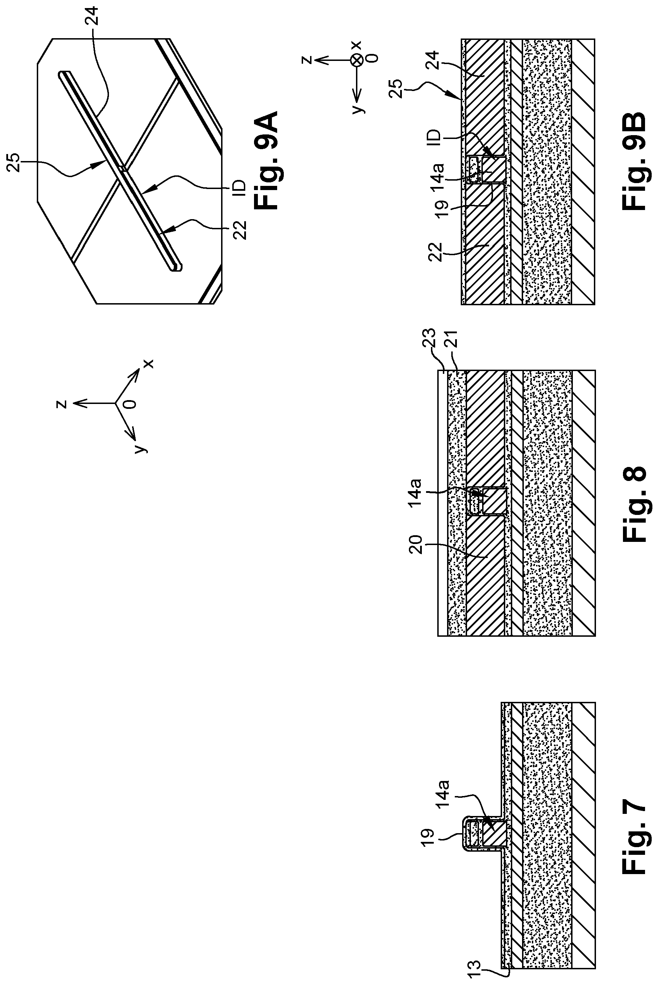

Une fine couche de diélectrique 19 tunnel, dont l'épaisseur par exemple comprise entre 1 nm et 5 nm, dépend du matériau choisi est ensuite déposée, en particulier sur les flancs latéraux du barreau 14a (figure 7). Le diélectrique 19 utilisé peut être par exemple du SiO₂ ou du HfO₂ formé par dépôt. En variante, on peut réaliser une oxydation du barreau 14a pour permettre de former un diélectrique 19 tunnel sur les flancs latéraux du barreau 14a.

On forme ensuite des blocs de grille de part et d'autre du ou des ilots de détection.

Pour cela, on dépose tout d'abord une couche d'au moins un matériau 20 conducteur ou semi-conducteur, avantageusement un matériau de grille identique à celui du barreau 14a, par exemple du polysilicium, qui peut être éventuellement dopé. La réalisation de motifs dans cette couche peut être précédée d'une étape de planarisation CMP (« Chemical mechanical planarization ») pour former ensuite un deuxième masquage sur une couche de préférence sans relief. Ce deuxième masquage peut être formé d'une, ou comme dans l'exemple de réalisation illustré sur la figure 8, de plusieurs couches 21, 23 de masque dur dans laquelle ou dans lesquelles on définit ensuite par gravure un ou plusieurs motifs, en particulier orthogonaux au barreau 14a.

On effectue ensuite une gravure anisotrope de la couche d'au moins un matériau 20 conducteur ou semi-conducteur typiquement à l'aide d'un plasma. Dans l'exemple particulier illustré sur les figures 9A-9B, la gravure anisotrope de la couche de matériau 20 conducteur ou semi-conducteur protégée par le masquage 25 est poursuivie jusqu'à atteindre la couche diélectrique 19 ou la couche isolante 13. Des blocs 22, 24 de grille sont ainsi formés de part et d'autre d'un ilot de détection ID.

Ces blocs 22, 24 de grille s'étendent principalement dans une direction orthogonale à celle du barreau 14a avant qu'il ne soit gravé. Un premier bloc grille 22 est disposé contre une région de la couche de diélectrique 19 tunnel agencée sur un flanc latéral de l'ilot de détection ID, de sorte à former une jonction tunnel entre le premier bloc 22 de grille et l'ilot de détection ID. Un deuxième bloc 24 de grille est disposé contre une région de la couche diélectrique tunnel 19 agencée sur un flanc latéral opposé dudit ilot de détection, de sorte à former une jonction tunnel entre le deuxième bloc 24 grille et l'ilot de détection.

Pour former les plots de contact 72, 74 sur les blocs de grille 22, 24 on peut ensuite former une ou plusieurs couches isolantes dans laquelle ou dans lesquelles on pratique des trous dont le fond atteint les blocs de grille. Puis, on remplit ces trous à l'aide d'un matériau conducteur, en particulier un matériau métallique tel que par exemple du W.

Dans le cas optionnel où l'on prévoit un plot conducteur 71 supplémentaire couplé à l'ilot de détection ID on forme un trou supplémentaire mais dont le fond est disposé à distance du bloc 14a d'accueil de l'ilot de détection ID. Ce trou supplémentaire peut être formé concomitamment aux trous d'accueils des plots de contacts 72, 74. Ce trou supplémentaire est alors ensuite rempli de matériau conducteur typiquement en même temps que les trous d'accueil précités.

Pour permettre de favoriser le contact entre les blocs de grille et les plots de contact, on peut prévoir, de manière optionnelle, de réaliser des régions d'alliage de métal et semi-conducteur sur les blocs 22, 24 de grille.

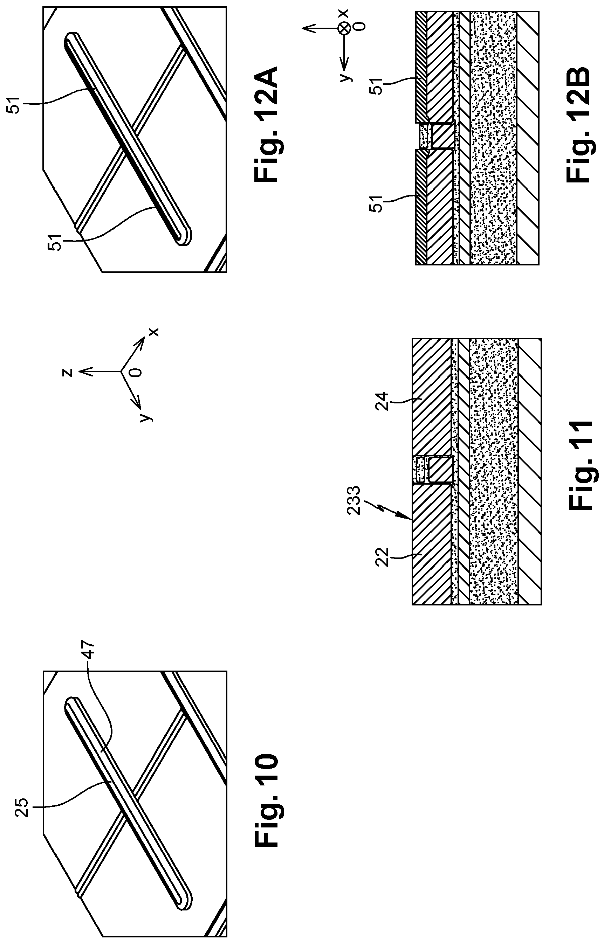

Un exemple de réalisation de ces régions d'alliage de métal et semi-conducteur est donné en liaison avec les figures 10, 11, 12A-12B.

Afin de ne réaliser les régions d'alliage que sur les faces supérieures des blocs de grille, on peut prévoir au préalable une encapsulation des faces latérales dévoilées de ces blocs 22, 24 de grille. Une telle encapsulation est illustrée par exemple sur la figure 10, où l'on réalise des espaceurs isolants 47, par exemple par dépôt puis gravure de matériau diélectrique tel par exemple du nitrure de silicium.

On peut ensuite, comme sur la figure 11, retirer le masquage 25 éventuellement préservé sur les blocs 22, 24 de grille pour dévoiler leurs faces supérieures 233. Dans le cas illustré où une couche de nitrure est à retirer au sommet des blocs de grille, sélectivement par rapport à une encapsulation latérale en SiO₂, une gravure chimique à base de H₃PO₄ peut être utilisée.

Puis, comme sur les figures 12A-12B, on forme les régions 51 à base d'alliage de métal et de semi-conducteur sur les faces supérieures 233 des blocs de grille 22, 24 afin de former des contacts ohmiques sur ces derniers. Une étape de dépôt d'au moins une couche de métal, par exemple du Ni, du Pt, du W, du Co, du Ti, peut être pour cela tout d'abord effectuée. Un traitement thermique est ensuite effectué pour réaliser la siliciuration. Un tel traitement peut être mis en œuvre à une température comprise par exemple entre 400°C et 500°C et une durée adaptée en fonction de la température de traitement. La gamme de température dépend fortement des matériaux utilisés et des phase d'alliage que l'on souhaite obtenir.

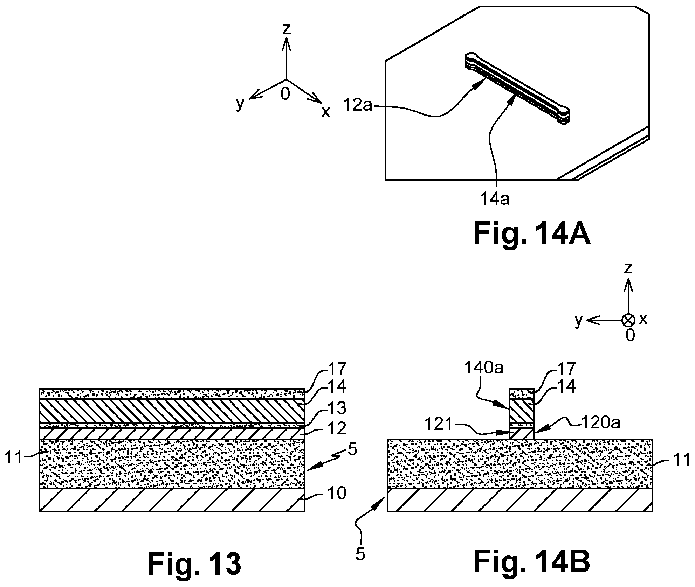

Une variante d'un procédé de fabrication pour la mise en œuvre d'un dispositif quantique du type de celui illustré par exemple sur la figure 2 va à présent être donné en liaison avec les figures 13 à 22.

On fabrique ici un dispositif dans lequel la ou les boites quantiques est ou sont confinées dans un bloc également appelé barreau semi-conducteur qui ne s'étend pas sur toute la surface du substrat.

Le matériau de départ peut être le même substrat 5 que dans l'exemple de réalisation précédemment décrit.

Ce substrat 5 peut être ensuite revêtu (figure 13) d'un empilement comprenant la première couche isolante 13, la couche 14 de matériau semi-conducteur ou conducteur, et la couche de masquage 17.

On définit alors un bloc 17a de masquage dans la couche de masquage 17 et l'on reporte le motif de ce masquage dans l'empilement de couches 12, 13, 14 sous-jacentes. Au moins une gravure anisotrope à l'aide d'un plasma est alors effectuée pour reproduire le motif du bloc de masquage dans la couche 14 de matériau de grille. Dans cet exemple de réalisation, la couche isolante 13 et la couche semi-conductrice 12 superficielle du substrat sont également gravées afin de reproduire ce même motif dans les couches isolante 13, et semi-conductrice 12.

Une structure susceptible d'être obtenue à l'issue de cette étape est représentée sur les figures 14A, 14B, (donnant respectivement une vue en perspective, une vue en coupe selon l'axe A'A). Un barreau 140a dit « supérieur » est formé à l'issue de la gravure de la couche 14. Dans ce barreau 140a plusieurs ilots de détection sont prévus. Un barreau 120a dit « inférieur » est quant à lui situé sous le barreau supérieur 140a et provient de la gravure de la couche semi-conductrice 12 superficielle. Dans l'exemple de réalisation particulier illustré, la gravure pour former le barreau supérieur 140a et le barreau inférieur 120a est arrêtée sur la couche isolante 11 du substrat 5.

Des flancs latéraux 121 du barreau 120a semi-conducteur sont dévoilés à l'issue de cette gravure. Afin d'éviter la possibilité d'un passage de courant entre les futurs blocs grille et le barreau 120a, on forme ensuite des blocs de protection isolants de part et d'autre des flancs latéraux 121 du barreau semi-conducteur 120a inférieur. Un oxyde déposé à haute température (HTO « Hight Themal Oxide ») peut être utilisé.

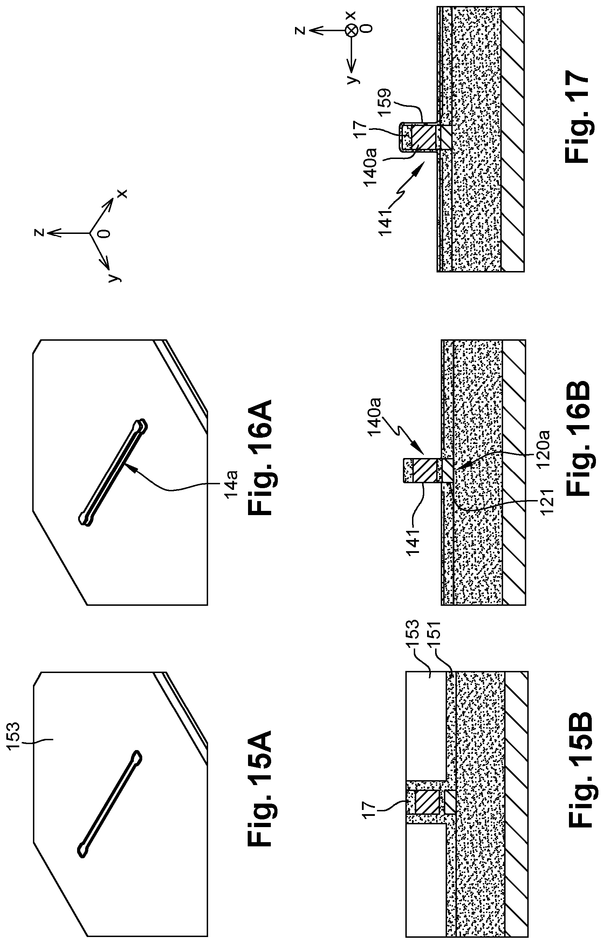

La réalisation de ces blocs de protection isolants peut, comme dans l'exemple de réalisation illustré sur les figures 15A-15B, comprendre le dépôt d'une première fine couche isolante 151, par exemple un oxyde de silicium thermique, d'épaisseur qui peut être comprise par exemple entre 5 nm et 20 nm. Ce dépôt peut être suivi du dépôt d'une couche isolante 153 plus épaisse, par exemple entre 50 nm et 200 nm et à base de SiO₂. L'épaisseur cumulée des couches isolantes 151, 153 peut être alors prévue supérieure à la hauteur de l'empilement revêtu de la couche de masquage 17. Dans ce cas, on réalise alors ensuite typiquement une planarisation (CMP) en s'arrêtant au niveau de la couche de masquage 17.

Un retrait partiel des couches isolantes 151, 153 est alors ensuite effectué (figures 16A-16B) de sorte à retirer ces couches isolantes 151, 153 autour du barreau supérieur 140a et dévoiler au moins une partie des faces latérales de ce barreau 140a supérieur, tout en préservant ces couches isolantes 151, 153 contre les flancs latéraux 121 du barreau 120a inférieur. Le retrait partiel des couches isolantes 151, 153 peut être réalisé par gravure humide par exemple à l'aide de HF.

Une fine couche de diélectrique 159 tunnel, par exemple d'une épaisseur comprise entre 1 nm et 5nm est alors ensuite formée, par dépôt sur les faces latérales 141 du barreau 140a supérieur ou bien par oxydation du barreau 14a supérieur. Dans l'exemple de réalisation particulier illustré sur la figure 17 la fine couche de diélectrique 159 tunnel recouvre également la couche de masquage 17 située au sommet de l'empilement des barreaux 120a, 140a. La fine couche de diélectrique 159 tunnel couche peut être par exemple à base d'oxyde de silicium et par exemple d'épaisseur comprise entre 1 et 2 nm.

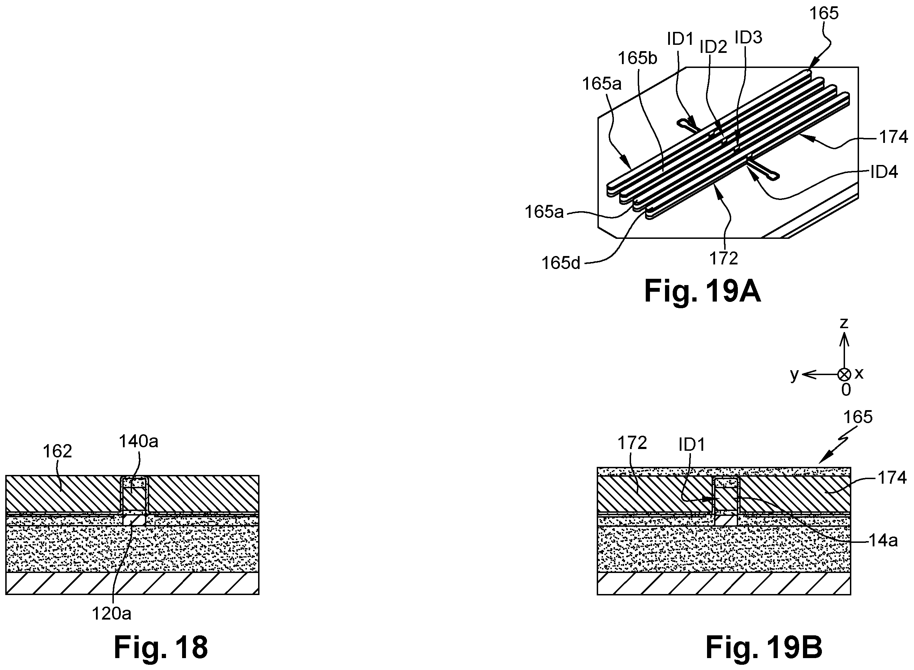

On forme ensuite les blocs de grille de part et d'autre de l'empilement des barreaux 120a inférieur et 140a supérieur superposés. Pour cela, on dépose tout d'abord (figure 18) une couche de matériau 162 conducteur ou semi-conducteur, de préférence un matériau de grille identique à celui du barreau 140a supérieur tel que par exemple du polysilicium. Une planarisation CMP est ensuite mise en œuvre afin de faire correspondre le niveau atteint par le matériau 162 conducteur ou semi-conducteur avec le sommet de l'empilement central dans lequel les barreaux 120a, 140 sont agencés.

Puis, on forme un deuxième masquage 165. Dans un cas où l'on vise à réaliser plusieurs ilots de détection et plusieurs paires de blocs de grille, le deuxième masquage 165 est formé de plusieurs blocs 165a, 165b, 165c, 165d distincts parallèles entre eux et qui s'étendent ici orthogonalement à la direction principale des barreaux 120a, 140a superposés (ladite direction principale étant une direction parallèle à l'axe x du repère [O ;x ;y ;z] donné sur les figures).

On effectue ensuite une gravure de la couche 162 de matériau de grille et du barreau 140a afin de retirer des zones de la couche de matériau 162 de grille et du barreau 140a non protégées par ces blocs 165a, 165b, 165c, 165d de masquage 165.

A l'issue d'une telle gravure, on obtient des paires de blocs 172, 174 de grille comme illustré sur les figures 19A-19B. Chaque paire de blocs de grille est associée et disposée de part et d'autre d'un ilot ID1, ID2, ID3, ID4 formé par une portion gravée du barreau 140a supérieur.

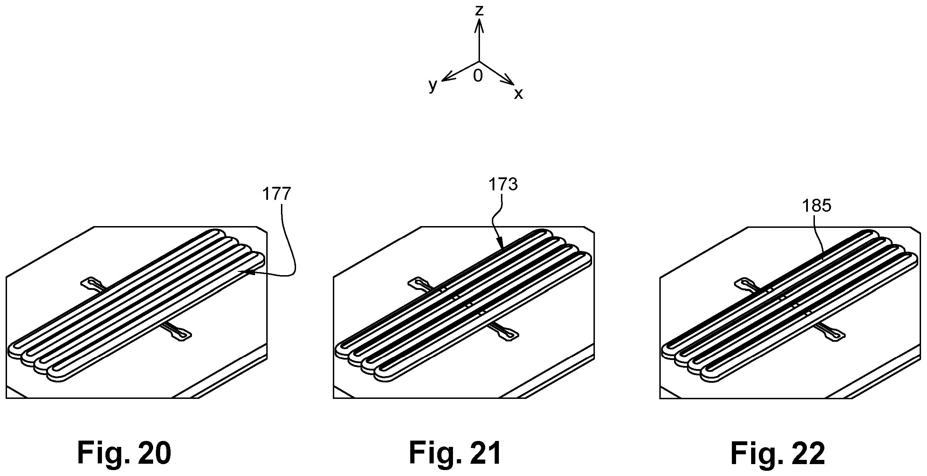

De même que pour l'exemple de procédé décrit précédemment, là encore, des étapes optionnelles de formation d'une encapsulation ou d'espaceurs isolants 177 de part sur les flancs latéraux des blocs de grille (figure 20), de retrait du deuxième masquage 165 sur la face supérieure 173 de ces blocs de grille (figure 21), puis de réalisation de régions 185 d'alliage de métal et de semi-conducteur, en particulier de régions siliciurées (figure 22) des blocs de grille afin de réaliser des contacts ohmiques peuvent être effectuées.

On peut ensuite former des plots de contact pour réaliser des prises de contact sur les blocs de grille. Des plots conducteurs en regard et à distance des ilots de détection peuvent être prévus afin de réaliser un moyen de contrôle électrostatique des ilots au-dessus de ces derniers.

Pour mettre en œuvre une structure telle que décrite précédemment en liaison avec la figure 3 où chaque ilot de détection peut n'être associé qu'à un seul bloc de grille, on adapte l'un ou l'autre des procédés décrits précédemment en formant un masquage 25 ou 165 qui ne s'étend que d'un premier côté de l'ilot afin de pouvoir retirer ensuite le matériau du ou des blocs de grille d'un deuxième côté de l'ilot opposé au premier côté. On peut ensuite suivre des étapes de procédé telles que décrites précédemment.

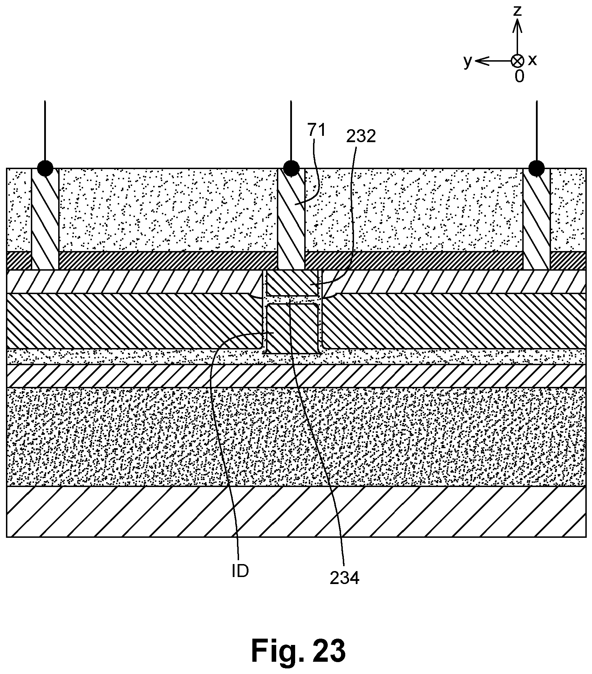

Dans une autre variante de réalisation, illustrée sur la figure 23, on prévoit de remplacer la couche de masquage 17 formée sur la figure 5 et typiquement en au moins un matériau isolant et/ou communément employé pour réaliser un masque dur, par une région 232 de matériau conducteur ou semi-conducteur. Avantageusement, le matériau employé pour former la région 232 est un matériau de grille qui peut être le même matériau que celui employé pour former l'ilot ID de détection, par exemple du polysilicium. Cela peut permettre de réaliser un contact amélioré avec un plot conducteur 71 qui peut être prévu au-dessus de l'ilot ID et qui est destiné à le contrôler par couplage électrostatique. Cela peut permettre d'avoir une région isolante 234 avec des propriétés diélectriques mieux contrôlées et de pouvoir mettre ainsi en œuvre un couplage électrostatique amélioré entre le plot conducteur 71 associé à la région 232 de matériau conducteur ou semi-conducteur et l'ilot de détection ID.

Avantageusement, la région 232 de matériau conducteur ou semi-conducteur, région isolante 234 et l'ilot de détection peuvent être formées concomitamment par le biais d'une même étape de gravure et/ou à travers un même masquage afin d'avoir sensiblement la même empreinte et reproduire un même motif.

Pour réaliser un contact du même type avec un plot 71 conducteur au-dessus et en regard de l'ilot ID, une autre méthode prévoit de remplacer la couche de matériau utilisée pour former l'ilot ID, en un empilement de plusieurs couches comportant une première couche conductrice ou semi-conductrice, par exemple en polysilicium, une couche isolante sur cette première couche conductrice ou semi-conductrice, et une deuxième couche conductrice ou semi-conductrice, de préférence en un matériau identique à celui de la première couche conductrice ou semi-conductrice, par exemple du polysilicium. Un masque dur utilisé pour graver cet empilement peut être alors retiré après réalisation de cette gravure et avant de former le plot conducteur 71. Ce plot conducteur 71 est alors formé typiquement par remplissage d'un trou pratiqué dans une couche isolante et qui débouche sur la deuxième couche conductrice ou semi-conductrice.

## Revendications

1. Dispositif quantique formé sur un substrat (5) et comprenant :
- un premier niveau dans lequel au moins une région semi-conductrice (12a, 120a) est agencée,
- un deuxième niveau dans lequel au moins un premier bloc de grille (22) est agencé et prévu pour moduler le potentiel d'une boite quantique (BQ) formée dans l'au moins une région semi-conductrice (12, 120) le deuxième niveau comprenant également une structure de détection d'un état de charge de la boite quantique, ladite structure de détection comportant un ilot de détection (ID) disposé au-dessus et en regard de la boite quantique (BQ) et apte à être couplé par couplage capacitif à la boite quantique, ladite structure de détection comportant en outre au moins une première jonction tunnel (JT1) entre ledit ilot de détection (ID) et le premier bloc (22) de grille, ledit ilot de détection (ID) et le premier bloc (22) de grille étant séparés par une région diélectrique tunnel, le premier bloc (22) de grille étant juxtaposé audit ilot de détection (ID), le premier bloc (22) de grille étant configuré pour former un réservoir de charges pour l'ilot de détection (ID).

2. Dispositif quantique selon la revendication 1, comportant au moins un deuxième bloc (24) grille distinct du premier bloc de grille (22) et situé dans un même premier plan (P) que le premier bloc (22) de grille et l'ilot de détection (ID), le premier plan étant parallèle à un plan principal du substrat (5), le deuxième bloc (24) de grille, étant agencé de sorte que l'ilot de détection (ID) est disposé entre le premier bloc (22) de grille et le deuxième bloc (24) de grille, la structure de détection de charge étant pourvue d'une deuxième jonction tunnel (JT2) formée entre l'ilot de détection (ID) et le deuxième bloc (24) de grille, l'ilot de détection (ID) et le deuxième bloc (24) de grille étant séparés par une autre région diélectrique tunnel.

3. Dispositif quantique selon la revendication 2, comportant en outre un premier plot de contact (72) sur le premier bloc (22) de grille et un deuxième plot de contact (74) sur le deuxième bloc (24) de grille.

4. Dispositif quantique selon la revendication 3, comprenant en outre un circuit de polarisation relié au premier plot de contact (72) et au deuxième plot de contact (74), le circuit de polarisation, le premier plot de contact (72) et le deuxième plot de contact (74) étant configurés pour :
- lors d'une phase de fonctionnement dite « de détection » appliquer respectivement un premier potentiel au premier bloc (22) de grille et un deuxième potentiel au deuxième bloc (24) de grille, différent du premier potentiel, de sorte à permettre le passage d'un courant à travers lesdites première et deuxième jonction (JT1, JT2) et,
- lors d'au moins une autre phase de fonctionnement distincte de ladite phase de fonctionnement de détection : appliquer un même potentiel donné au premier bloc (22) de grille et au deuxième bloc (24) de grille.

5. Dispositif quantique selon la revendication 4, dans lequel le premier plot (72) de contact et le deuxième plot (74) de contact sont couplés à un étage de mesure du courant à travers lesdites première jonction (JT1) et deuxième jonction (JT2).

6. Dispositif quantique selon l'une des revendications 1 à 3, comportant en outre un dispositif de mesure par réflectométrie et un premier plot de contact (72) sur le premier bloc (22) de grille, le premier plot de contact (72) étant couplé à un circuit (350) dudit dispositif de mesure par réflectométrie, ledit circuit (350) étant en particulier configuré pour :
- émettre un signal RF sur le premier plot de contact à destination dudit ilot ;
- détecter une variation d'impédance par le biais d'un changement d'amplitude ou de phase du signal RF réfléchi par ledit ilot.

7. Dispositif quantique selon l'une des revendications 1 à 6, dans lequel la structure de détection est munie d'un plot conducteur (71) pour un contrôle électrostatique dudit ilot de détection (ID), ledit plot conducteur (71) étant disposé au-dessus et en regard dudit ilot de détection (ID) et séparé dudit ilot de détection par le biais d'au moins une région diélectrique (RDI, 234) de sorte à permettre un couplage électrostatique entre ledit plot conducteur (71) et ledit ilot de détection (ID).

8. Dispositif quantique selon l'une des revendications 1 à 6, dans lequel le plot conducteur (71) est disposé en contact d'une région de matériau (232) conducteur ou semi-conducteur dopé séparée de l'ilot de détection (ID) par l'intermédiaire d'une région diélectrique (234), ladite région de matériau (232) conducteur ou semi-conducteur dopé, ladite région diélectrique (234), ledit ilot de détection (ID) ayant une même empreinte et formant un même motif.

9. Dispositif quantique selon l'une des revendications 1 à 8, dans lequel l'ilot de détection (ID) est à base d'un même matériau conducteur ou semi-conducteur dopé que le ou les blocs (22, 24) de grille.

10. Procédé de fabrication d'un dispositif quantique selon l'une des revendications précédentes, comprenant les étapes suivantes :
- prévoir un substrat (5) revêtu d'au moins une couche semi-conductrice (12) dotée d'au moins une région (12a, 120a) dans laquelle une boite quantique est apte à être formée,
- former un barreau (14a, 140a) à base d'au moins un matériau conducteur ou semi-conducteur dopé dans lequel au moins un ilot de détection en regard de ladite boite quantique est prévu,
- former au moins une région de diélectrique tunnel (19, 159) sur au moins un flanc latéral dudit barreau (14a, 140a),
- former un ou plusieurs blocs (22, 24, 172, 174) de grille juxtaposés audit barreau (14a, 140a) et s'étendant principalement dans une direction orthogonale à une direction principale dans laquelle s'étend ledit barreau (14a, 140a), au moins un premier bloc grille parmi lesdits blocs de grille étant disposé contre la région de diélectrique tunnel agencée sur ledit ilot de détection, de sorte à former une jonction tunnel entre le premier bloc grille et l'ilot de détection.

11. Procédé selon la revendication 10, dans lequel lesdits un ou plusieurs blocs (22, 24, 172, 174) de grille sont formés par :
- dépôt d'au moins un matériau de grille, puis :
- gravure dudit matériau de grille, ladite gravure étant réalisée concomitamment à une gravure du barreau (14a, 140a) pour former l'ilot de détection.

12. Procédé selon la revendication 10, ledit barreau (14a, 140a) étant à base dudit matériau de grille.

13. Procédé selon l'une des revendications 11 ou 12, dans lequel la région de diélectrique tunnel est formée par dépôt d'une couche de diélectrique (19, 159) tunnel sur le barreau (14a, 140a) puis par gravure de la couche diélectrique (19, 159) tunnel, la gravure de la couche diélectrique tunnel et la gravure dudit barreau (14a, 140a) pour former l'ilot de détection et la gravure dudit matériau de grille étant effectuées en utilisant un même masquage.

14. Procédé selon l'une des revendication 10 à 13, dans lequel la région de diélectrique tunnel est formée par oxydation dudit barreau.

15. Procédé selon l'une des revendications 10 à 14, dans lequel ledit barreau est dit « supérieur » et formé par dépôt d'un matériau conducteur puis gravure du matériau conducteur en utilisant un masquage, ladite gravure du matériau conducteur étant prolongée dans la couche semi-conductrice (12) et de sorte à former un autre barreau (120a) dit « inférieur ».

16. Procédé selon la revendication 15, dans lequel à l'issue de ladite gravure de sorte à former ledit autre barreau inférieur (120a), des flancs latéraux (121) du barreau inférieur (120a) sont dévoilés, le procédé comprenant en outre : après formation dudit barreau inférieur (120a) et préalablement à la formation de ladite région de diélectrique tunnel, des étapes de :
- dépôt d'un ou plusieurs couches isolantes (151, 153),
- gravure desdites une ou plusieurs couches isolantes (151, 153) de sorte à former des blocs de protection isolants de part et d'autre des faces latérales de la région semi-conductrice,
- formation d'une région de diélectrique tunnel par dépôt d'une couche de diélectrique (159) tunnel sur le barreau supérieur (140a) tandis que des flancs latéraux du barreau inférieur (120a) sont protégés.

## Patentansprüche

1. Quantenvorrichtung, die auf einem Substrat (5) gebildet ist und umfasst:
- eine erste Ebene, in der mindestens ein Halbleiterbereich (12a, 120a) angeordnet ist,
- eine zweite Ebene, in der mindestens ein erster Gate-Block (22) angeordnet und vorgesehen ist, um das Potenzial eines Quantenpunkts (BQ) zu modulieren, der in dem mindestens einen Halbleiterbereich (12, 120) gebildet ist, wobei die zweite Ebene auch eine Detektionsstruktur für einen Ladezustand des Quantenpunkts umfasst, wobei die Detektionsstruktur eine Detektionsinsel (ID) beinhaltet, die oberhalb und gegenüber des Quantenpunkts (BQ) angeordnet ist und imstande ist, durch kapazitive Kopplung mit dem Quantenpunkt gekoppelt zu werden, die Detektionsstruktur weiter mindestens einen ersten Tunnelübergang (JT1) zwischen der Detektionsinsel (ID) und dem ersten Gate-Block (22) beinhaltet, wobei die Detektionsinsel (ID) und der erste Gate-Block (22) durch einen dielektrischen Tunnelbereich voneinander getrennt sind, wobei der erste Gate-Block (22) der Detektionsinsel (ID) benachbart ist, wobei der erste Gate-Block (22) konfiguriert ist, um einen Ladungsspeicher für die Detektionsinsel (ID) zu bilden.

2. Quantenvorrichtung nach Anspruch 1, die mindestens einen zweiten Gate-Block (24) beinhaltet, der sich vom ersten Gate-Block (22) unterscheidet und sich in einer gleichen ersten Ebene (P) befindet wie der erste Gate-Block (22) und die Detektionsinsel (ID), wobei die erste Ebene parallel zu einer Hauptebene des Substrats (5) verläuft, wobei der zweite Gate-Block (24) angeordnet ist, sodass die Detektionsinsel (ID) zwischen dem ersten Gate-Block (22) und dem zweiten Gate-Block (24) angeordnet ist, wobei die Ladungsdetektionsstruktur mit einem zweiten Tunnelübergang (JT2) versehen ist, der zwischen der Detektionsinsel (ID) und dem zweiten Gate-Block (24) gebildet ist, wobei die Detektionsinsel (ID) und der zweite Gate-Block (24) durch einen weiteren dielektrischen Tunnelbereich voneinander getrennt sind.

3. Quantenvorrichtung nach Anspruch 2, die weiter einen ersten Kontaktstift (72) am ersten Gate-Block (22) und einen zweiten Kontaktstift (74) am zweiten Gate-Block (24) beinhaltet.

4. Quantenvorrichtung nach Anspruch 3, die weiter eine Polarisationsschaltung umfasst, die mit dem ersten Kontaktstift (72) und dem zweiten Kontaktstift (74) verbunden ist, wobei die Polarisationsschaltung, der erste Kontaktstift (72) und der zweite Kontaktstift (74) konfiguriert sind, um:
- bei einer sogenannten "Detektionsbetriebsphase" jeweils ein erstes Potenzial an den ersten Gate-Block (22) und ein zweites Potenzial an den zweiten Gate-Block (24), das sich vom ersten Potenzial unterscheidet, anzulegen, um den Durchfluss eines Stroms durch den ersten und den zweiten Übergang (JT1, JT2) zu ermöglichen, und
- bei mindestens einer weiteren Betriebsphase, die sich von der Detektionsbetriebsphase unterscheidet: Anlegen eines gleichen gegebenen Potenzials an den ersten Gate-Block (22) und an den zweiten Gate-Block (24).

5. Quantenvorrichtung nach Anspruch 4, wobei der erste Kontaktstift (72) und der zweite Kontaktstift (74) durch den ersten Übergang (JT1) und den zweiten Übergang (JT2) mit einer Strommessstufe gekoppelt sind.

6. Quantenvorrichtung nach einem der Ansprüche 1 bis 3, die weiter eine Reflektrometrie-Messvorrichtung und einen ersten Kontaktstift (72) am ersten Gate-Block (22) beinhaltet, wobei der erste Kontaktstift (72) mit einer Schaltung (350) der Reflektrometrie-Messvorrichtung gekoppelt ist,
wobei die Schaltung (350) insbesondere konfiguriert ist, um:
- ein HF-Signal auf dem ersten Kontaktstift zur betreffenden Insel zu senden;
- eine Impedanzvariation durch eine Amplituden- oder Phasenänderung des von der Insel reflektierten HF-Signals zu detektieren.

7. Quantenvorrichtung nach einem der Ansprüche 1 bis 6, wobei die Detektionsstruktur mit einem leitfähigen Stift (71) zur elektrostatischen Steuerung der Detektionsinsel (ID) versehen ist, wobei der leitfähige Stift (71) oberhalb und gegenüber der Detektionsinsel (ID) angeordnet und von der Detektionsinsel durch mindestens einen dielektrischen Bereich (RDI, 234) getrennt ist, um eine elektrostatische Kopplung zwischen dem leitfähigen Stift (71) und der Detektionsinsel (ID) zu ermöglichen.

8. Quantenvorrichtung nach einem der Ansprüche 1 bis 6, wobei der leitfähige Stift (71) in Kontakt mit einem Bereich aus dotiertem Leiter- oder Halbleitermaterial (232) angeordnet ist, der durch einen dielektrischen Bereich (234) von der Detektionsinsel (ID) getrennt ist, wobei der Bereich aus dotiertem Leiter- oder Halbleitermaterial (232), der dielektrische Bereich (234), die Detektionsinsel (ID) einen gleichen Abdruck aufweisen und ein gleiches Muster bilden.

9. Quantenvorrichtung nach einem der Ansprüche 1 bis 8, wobei die Detektionsinsel (ID) auf einem gleichen dotierten Leiter- oder Halbleitermaterial basiert wie der oder die Gate-Blöcke (22, 24).

10. Verfahren zur Herstellung einer Quantenvorrichtung nach einem der vorstehenden Ansprüche, umfassend die folgenden Schritte:
- Vorsehen eines Substrats (5), das mit mindestens einer Halbleiterschicht (12) beschichtet ist, die mit mindestens einem Bereich (12a, 120a) ausgestattet ist, in dem ein Quantenpunkt imstande ist, gebildet zu werden,
- Bilden eines Stabs (14a, 140a) auf Basis von mindestens einem dotierten Leiter- oder Halbleitermaterial, in dem mindestens eine Detektionsinsel gegenüber dem Quantenpunkt vorgesehen ist,
- Bilden mindestens eines dielektrischen Tunnelbereichs (19, 159) an mindestens einer Seitenflanke des Stabs (14a, 140a),
- Bilden eines oder mehrerer Gate-Blöcke (22, 24, 172, 174), die dem Stab (14a, 140a) benachbart sind, und sich hauptsächlich in einer orthogonalen Richtung zu einer Hauptrichtung erstrecken, in der sich der Stab (14a, 140a) erstreckt, wobei mindestens ein erster Gate-Block unter den Gate-Blöcken an dem auf der Detektionsinsel angeordneten dielektrischen Tunnelbereich angeordnet ist, um einen Tunnelübergang zwischen dem ersten Gate-Block und der Detektionsinsel zu bilden.

11. Verfahren nach Anspruch 10, wobei der eine oder mehrere Gate-Blöcke (22, 24, 172, 174) gebildet werden durch:
- Abscheiden mindestens eines Gate-Materials, danach:
- Ätzen des Gate-Materials, wobei das Ätzen gleichzeitig mit einem Ätzen des Stabs (14a, 140a) durchgeführt wird, um die Detektionsinsel zu bilden.

12. Verfahren nach Anspruch 10, wobei der Stab (14a, 140a) auf dem Gate-Material basiert.

13. Verfahren nach einem der Ansprüche 11 oder 12, wobei der dielektrische Tunnelbereich durch Abscheiden einer dielektrischen Tunnelschicht (19, 159) auf den Stab (14a, 140a) und danach durch Ätzen der dielektrischen Tunnelschicht (19, 159) gebildet wird, wobei das Ätzen der dielektrischen Tunnelschicht und das Ätzen des Stabs (14a, 140a) zum Bilden der Detektionsinsel und das Ätzen des Gate-Materials unter Verwendung einer gleichen Maskierung durchgeführt werden.

14. Verfahren nach einem der Ansprüche 10 bis 13, wobei der dielektrische Tunnelbereich durch Oxidation des Stabs gebildet wird.

15. Verfahren nach einem der Ansprüche 10 bis 14, wobei der Stab als "oberer Stab" bezeichnet wird und durch Abscheiden eines Leitermaterials und danach Ätzen des Leitermaterials unter Verwendung einer Maskierung gebildet wird, wobei das Ätzen des Leitermaterials bis in die Halbleiterschicht (12) fortgesetzt wird und in der Art, um einen weiteren als "unteren" bezeichneten Stab (120a) zu bilden.

16. Verfahren nach Anspruch 15, wobei nach Abschluss des Ätzens in der Art, um den weiteren unteren Stab (120a) zu bilden, Seitenflanken (121) des unteren Stabs (120a) freigelegt werden, wobei das Verfahren weiter umfasst: nach Bilden des unteren Stabs (120a) und vor dem Bilden des dielektrischen Tunnelbereichs die Schritte zum:
- Abscheiden einer oder mehrerer Isolierschichten (151, 153),
- Ätzen der einen oder mehrerer Isolierschichten (151, 153), um beiderseits der Seitenflächen des Halbleiterbereichs isolierende Schutzblöcke zu bilden,
- Bilden eines dielektrischen Tunnelbereichs durch Abscheiden einer dielektrischen Tunnelschicht (159) auf dem oberen Stab (140a), während Seitenflanken des unteren Stabs (120a) geschützt werden.

## Claims

1. Quantum device formed on a substrate (5) and comprising:
- a first level wherein at least one semiconductor region (12a, 120a) is arranged,
- a second level wherein at least one first gate block (22) is arranged and designed to modulate the potential of a quantum dot (BQ) formed in the at least one semiconductor region (12, 120), the second level also comprising a structure for detecting a state of charge of the quantum dot, said detection structure including a detection island (ID) disposed above and facing the quantum dot (BQ) and able to be coupled to the quantum dot by capacitive coupling, said detection structure furthermore including at least one first tunnel junction (JT1) between said detection island (ID) and the first gate block (22), said detection island (ID) and the first gate block (22) being separated by a tunnel dielectric, the first gate block (22) being juxtaposed with said detection island (ID), the first gate block (22) being configured to form a reservoir of charges for the detection island (ID).

2. Quantum device according to claim 1, including at least one second gate block (24) distinct from the first gate block (22) and located in the same first plane (P) as the first gate block (22) and the detection island (ID), the first plane being parallel to a principal plane of the substrate (5), the second gate block (24) being arranged so that the detection island (ID) is disposed between the first gate block (22) and the second gate block (24), the charge detection structure being provided with a second tunnel junction (JT2) formed between the detection island (ID) and the second gate block (24), the detection island (ID) and the second gate block (24) being separated by another tunnel dielectric.

3. Quantum device according to claim 2, furthermore including a first contact pad (72) on the first gate block (22) and a second contact pad (74) on the second gate block (24).

4. Quantum device according to claim 3, furthermore comprising a biasing circuit connected to the first contact pad (72) and to the second contact pad (74), the biasing circuit, the first contact pad (72) and the second contact pad (74) being configured to:
- during a so-called "detection" operating phase, apply respectively a first potential to the first gate block (22) and a second potential to the second gate block (24) different from the first potential so as to allow passage of a current through said first and second junctions (JT1, JT2), and
- during at least one other operating phase distinct from said detection operating phase: apply one and the same given potential to the first gate block (22) and to the second gate block (24).

5. Quantum device according to claim 4, wherein the first contact pad (72) and the second contact pad (74) are coupled to a current-measuring stage through said first junction (JT1) and second junction (JT2).

6. Quantum device according to one of claims 1 to 3, further including a refractometry measuring device and a first contact pad (72) on the first gate block (22), the first contact pad (72) being coupled to a circuit (350) of said refractometry measuring device, said circuit (350) being in particular configured to:
- emit an RF signal on the first contact pad intended for said island;
- detect a variation in impedance by means of a change in amplitude or phase of the RF signal reflected by said island.

7. Quantum device according to one of claims 1 to 6, wherein the detection structure is provided with a conductive pad (71) for electrostatic control of said detection island (ID), said conductive pad (71) being disposed above and facing said detection island (ID) and separated from said detection island by means of at least one dielectric region (RDI, 234) so as to allow electrostatic coupling between said conductive pad (71) and said detection island (ID).

8. Quantum device according to one of claims 1 to 6, wherein the conductive pad (71) is disposed in contact with a region of doped conductive or semiconductor material (232) separated from the detection island (ID) by means of a dielectric region (234), said region of doped conductive or semiconductor material (232), said dielectric region (234) and said detection island (ID) having the same imprint and forming the same pattern.

9. Quantum device according to one of claims 1 to 8, wherein the detection island (ID) is based on the same doped conductive or semiconductor material as the gate block or blocks (22, 24).

10. Method for manufacturing a quantum device according to one of the preceding claims, comprising the following steps:
- providing a substrate (5) covered with at least one semiconductor layer (12) provided with at least one region (12a, 120a) wherein a quantum dot is able to be formed,
- forming a bar (14a, 140a) based on at least one conductive or semiconductor material wherein at least one detection island facing said quantum dot is provided,
- forming at least one tunnel dielectric region (19, 159) on at least one lateral side of said bar (14a, 140a),
- forming one or more gate blocks (22, 24, 172, 174) juxtaposed with said bar (14a, 140a) and extending mainly in a direction orthogonal to a principal direction in which said bar (14a, 140a) extends, at least one first gate block from said gate blocks being disposed against the tunnel dielectric region arranged on said detection island, so as to form a tunnel junction between the first gate block and the detection island.

11. Method according to claim 10, wherein said one or more gate blocks (22, 24, 172, 174) are formed by:
- depositing at least one gate material, then:
- etching said gate material, said etching being implemented concomitantly with an etching of the bar (14a, 140a) to form the detection island.

12. Method according to claim 10, said bar (14a, 140a) being based on said gate material.

13. Method according to one of claims 11 or 12, wherein the tunnel dielectric region is formed by depositing a tunnel dielectric layer (19, 159) on the bar (14a, 140a) and then by etching the tunnel dielectric layer (19, 159), the etching of the tunnel dielectric layer and the etching of said bar (14a, 140a) to form the detection island and the etching of said gate material being implemented using one and the same masking.

14. Method according to one of claims 10 to 13, wherein the tunnel dielectric region is formed by oxidising said bar.

15. Method according to one of claims 10 to 14, wherein said bar is called the "upper bar" and is formed by depositing a conductive material and then etching the conductive material using a masking, said etching of the conductive material being extended into the semiconductor layer (12) so as to form another so-called "lower" bar (120a).

16. Method according to claim 15, wherein, at the end of said etching so as to form said other lower bar (120a), lateral sides (121) of the lower bar (120a) are revealed, the method furthermore comprising: after forming said lower bar (120a) and prior to the formation of said tunnel dielectric region, steps of:
- depositing one or more insulating layers (151, 153),
- etching said one or more insulating layers (151, 153) so as to form insulating protective blocks on either side of the lateral faces of the semiconductor region,
- forming a tunnel dielectric region by depositing a tunnel dielectric layer 159) on the upper bar (140a) while lateral sides of the lower bar (120a) are protected.
